# EUROPÄISCHE PATENTSCHRIFT

(11) **EP 1 450 210 B1**
(45) Veröffentlichungstag und Bekanntmachung des Hinweises auf die Patenterteilung: **28.12.2016**
(21) Anmeldenummer: 03020313.7
(22) Anmeldetag: 09.09.2003
(51) Int. Cl.: G03F 9/00, B41C 1/10, B41F 33/00

(54) **Vorrichtung und Verfahren zur Erkennung der Kante eines Aufzeichnungsmaterials**
Apparatus and method for detecting the edge of a recording material
Appareil et méthode pour détecter le bord d'un matériau d'enregistrement

(30) Priorität: 21.02.2003 DE 10307381
(43) Veröffentlichungstag der Anmeldung: 25.08.2004
(73) Patentinhaber: Heidelberger Druckmaschinen AG, 69115 Heidelberg (DE)
(72) Erfinder: Blöhdorn, Gerhard Fritz, 24232 Schönkirchen (DE); Melzer, Peter, 24146 Kiel (DE); Franke, Heinz Gerhard, 24107 Kiel (DE); Haushahn, Volker, 24111 Kiel (DE)

(56) Entgegenhaltungen:
- EP-A- 0 015 553
- EP-A- 0 847 857
- EP-A- 1 279 920
- DE-A- 3 336 726
- GB-A- 690 056
- US-A- 5 956 071

## Beschreibung

Die Erfindung bezieht sich auf das Gebiet der elektronischen Reproduktionstechnik und betrifft eine Vorrichtung und ein Verfahren zur Erkennung der Kante eines Aufzeichnungsmaterials, beispielsweise einer Druckplatte, in einem Belichter zur Aufzeichnung von Druckvorlagen.

In der Reproduktionstechnik werden Druckvorlagen für Druckseiten erzeugt, die alle zu druckenden Elemente wie Texte, Grafiken und Bilder enthalten. Für den farbigen Druck wird für jede Druckfarbe eine separate Druckvorlage erzeugt, die alle Elemente enthält, die in der jeweiligen Farbe gedruckt werden. Für den Vierfarbdruck sind das die Druckfarben Cyan, Magenta, Gelb und Schwarz (CMYK). Die nach Druckfarben separierten Druckvorlagen werden auch Farbauszüge genannt. Die Druckvorlagen werden in der Regel gerastert und mit einem Belichter auf Filme belichtet, mit denen dann Druckplatten für das Drucken hoher Auflagen hergestellt werden. Alternativ können die Druckvorlagen in speziellen Belichtungsgeräten auch gleich auf Druckplatten belichtet werden oder sie werden direkt als digitale Daten an eine digitale Druckmaschine übergeben. Dort werden die Druckvorlagendaten dann beispielsweise mit einer in die Druckmaschine integrierten Belichtungseinheit auf Druckplatten belichtet, bevor unmittelbar anschließend der Auflagendruck beginnt.

Nach dem heutigen Stand der Technik werden die Druckvorlagen elektronisch reproduziert. Dabei werden Bilder in einem Farbscanner gescannt und in Form von digitalen Daten gespeichert. Texte werden mit Textverarbeitungsprogrammen erzeugt und Grafiken mit Zeichenprogrammen. Mit einem Layoutprogramm werden die Bild-, Text- und Grafik-Elemente zu einer Druckseite zusammengestellt. Nach der Separation in die Druckfarben liegen die Druckvorlagen dann in digitaler Form vor. Als Datenformate zur Beschreibung der Druckvorlagen werden heute weitgehend die Seitenbeschreibungssprachen Postscript und PDF (Portable Document Format) verwendet. Die Postscript- bzw. PDF-Daten werden vor der Aufzeichnung der Druckvorlagen in einem Raster-Image-Prozessor (RIP) in einem ersten Schritt in Farbauszugswerte für die Farbauszüge CMYK umgerechnet. Dabei entstehen für jeden Bildpunkt vier Farbauszugswerte als Tonwerte im Wertebereich von 0 bis 100%. Die Farbauszugswerte sind ein Maß für die Farbdichten, mit denen die vier Druckfarben Cyan, Magenta, Gelb und Schwarz auf dem Bedruckstoff gedruckt werden. In Sonderfällen, in denen mit mehr als vier Farben gedruckt wird (Schmuckfarben), ist jeder Bildpunkt durch so viele Farbauszugswerte beschrieben, wie es Druckfarben gibt. Die Farbauszugswerte können z.B. mit 8 bit je Bildpunkt und Druckfarbe als Datenwert gespeichert sein, womit der Wertebereich von 0 % bis 100% in 256 Tonwertstufen unterteilt ist.

Die Daten mehrerer Druckseiten werden mit den Daten weiterer Elemente, wie Passkreuzen, Schnittmarken und Falzmarken sowie Druckkontrollfeldern, zu Druckvorlagen für einen Druckbogen zusammengefasst. Diese Druckbogendaten werden ebenfalls als Farbauszugswerte (CMYK) bereit gestellt.

Unterschiedliche Tonwerte eines zu reproduzierenden Farbauszugs lassen sich im Druck nur durch eine Flächenmodulation der aufgetragenen Druckfarben, d.h. durch eine Rasterung, wiedergeben. Die Flächenmodulation der Druckfarben kann beispielsweise nach einem Verfahren zur Punktrasterung erfolgen, bei dem die verschiedenen Tonwertstufen der Farbauszugsdaten in Rasterpunkte unterschiedlicher Größe umgewandelt werden, die in einem regelmäßigen Raster mit sich periodisch wiederholenden Rasterzellen angeordnet sind. Bei der Aufzeichnung der Farbauszüge auf eine Druckplatte werden die Rasterpunkte in den einzelnen Rasterzellen aus Belichtungspunkten zusammengesetzt, die um eine Größenordnung kleiner als die Rasterpunkte sind. Eine typische Auflösung der Belichtungspunkte ist beispielsweise 1000 Belichtungspunkte je Zentimeter, d.h. ein Belichtungspunkt hat die Abmessungen 10 µm × 10 µm. Die Umsetzung der Farbauszugswerte in Rasterpunkte geschieht in einem zweiten Schritt bei der weiteren Verarbeitung der Farbauszugsdaten im Raster-Image-Prozessor, wodurch die Farbauszugsdaten in hochaufgelöste Binärwerte mit nur zwei Helligkeitswerten (belichtet bzw. nicht belichtet) umgewandelt werden, die das Muster des modulierten Punktrasters bilden. Auf diese Weise werden die Druckvorlagendaten jedes Farbauszugs in Form einer hochaufgelösten Rasterbitmap beschrieben, die für jeden der Belichtungspunkte auf der Druckfläche ein Bit enthält, das angibt, ob dieser Belichtungspunkt zu belichten ist oder nicht.

In den Aufzeichnungsgeräten, die in der elektronischen Reproduktionstechnik zur Belichtung von Druckvorlagen und Druckformen eingesetzt werden, wird beispielsweise ein Laserstrahl von einer Laserdiode erzeugt, durch optische Mittel geformt und auf das Aufzeichnungsmaterial fokussiert und mittels eines Ablenksystems Punkt- und Linienweise über das Aufzeichnungsmaterial abgelenkt. Es gibt auch Aufzeichnungsgeräte, die zur Erhöhung der Belichtungsgeschwindigkeit ein Bündel von Laserstrahlen erzeugen, z.B. mit einer separaten Laserdiode für jeden Laserstrahl, und mit jedem Überstreichen des Aufzeichnungsmaterials mehrere Bildlinien der Druckform gleichzeitig belichten. Die Druckformen können auf Filmmaterial belichtet werden, so dass sogenannte Farbauszugsfilme entstehen, die anschließend mittels eines fotografischen Umkopierverfahrens zur Herstellung von Druckplatten dienen. Statt dessen können auch die Druckplatten selbst in einem Plattenbelichter oder direkt in einer digitalen Druckmaschine belichtet werden, in die eine Einheit zur Plattenbelichtung integriert ist. Das Aufzeichnungsmaterial kann sich auf einer Trommel befinden (Außentrommelbelichter), in einer zylindrischen Mulde (Innentrommelbelichter) oder auf einer ebenen Fläche (Flachbettbelichter).

Bei einem Außentrommelbelichter wird das zu belichtende Material in Form von Filmen oder Druckplatten auf eine drehbar gelagerte Trommel montiert. Während die Trommel rotiert, wird ein Belichtungskopf in einem relativ kurzen Abstand axial an der Trommel entlang bewegt. Der Belichtungskopf fokussiert einen oder mehrere Laserstrahlen auf die Trommeloberfläche, die die Trommeloberfläche in Form einer engen Schraubenlinie überstreichen. Auf diese Weise werden bei jeder Trommelumdrehung eine bzw. mehrere Bildlinien auf das Aufzeichnungsmaterial belichtet.

Bei einem Innentrommelbelichter wird das zu belichtende Material auf der Innenfläche eines teilweise offenen Hohlzylinders montiert und mit einem Laserstrahl belichtet, der entlang der Zylinderachse auf eine Ablenkvorrichtung gerichtet wird, die den Laserstrahl senkrecht auf das Material reflektiert. Die Ablenkvorrichtung, ein Prisma oder ein Spiegel, rotiert im Betrieb mit hoher Drehzahl und wird dabei in Richtung der Zylinderachse bewegt, so dass der abgelenkte Laserstrahl kreisförmige oder schraubenförmige Bildlinien auf dem Material beschreibt.

Flachbettbelichter arbeiten überwiegend mit einem schnell rotierenden Polygonspiegel, dessen Spiegelflächen den Laserstrahl quer über das Aufzeichnungsmaterial lenken, während gleichzeitig das Aufzeichnungsmaterial senkrecht zur Ablenkrichtung des Laserstrahls bewegt wird. Auf diese Weise wird Bildlinie für Bildlinie belichtet. Da sich bei der Bewegung des Laserstrahls über das Aufzeichnungsmaterial die Länge des Lichtwegs ändert, ist eine aufwendige Abbildungsoptik erforderlich, die die dadurch bedingte Größenänderungen des Belichtungspunktes kompensiert.

Unabhängig von der Bauform des Belichters werden die Laserstrahlen bei der Belichtung der Druckvorlagen nicht mit einem kontinuierlich variierenden Signal moduliert, sondern sie werden abhängig von einem aus der Rasterbitmap gewonnenen binären Bildsignal ein- und ausgeschaltet, so dass ein der Rasterbitmap entsprechendes Muster von Rasterpunkten aufgezeichnet wird.

Bei der Belichtung der Druckvorlagen muss dafür gesorgt werden, dass die Lage der Belichtungsfläche bezogen auf die Kanten des Aufzeichnungsmaterials oder mit Bezug auf die in die vordere Kante gestanzten Löcher für alle Farbauszüge eines Druckbogens immer gleich ist, da die Farbauszüge später in der Druckmaschine deckungsgleich übereinander gedruckt werden sollen. Die Stanzlöcher in den Druckplatten dienen zur richtigen Positionierung beim Aufspannen der Druckplatten auf den Plattenzylinder in der Druckmaschine. Die Lage der Belichtungsfläche und die Lage der Stanzlöcher werden bezogen auf eine vordere Kante und eine oder beide seitliche Kanten des Aufzeichnungsmaterials bestimmt.

Die Toleranz der verbleibenden Verschiebung zwischen den Farbauszügen sollte kleiner als 25 µm sein. Der immer gleiche Bezug zur vorderen Kante wird zum Beispiel durch Anlagestifte gewährleistet, an die die vordere Kante des Aufzeichnungsmaterials vor der Belichtung beim Einspannen des Materials in das Belichtungsgerät angelegt wird. Dabei kann jedoch durch mechanische Toleranzen der Einspannvorrichtung eine seitliche Verschiebung des Aufzeichnungsmaterials vorkommen. Deshalb ist es erforderlich, die genaue Lage der seitlichen Kanten nach dem Einspannen zu ermitteln, damit die so ermittelten Kantenpositionen in Beziehung zur Position des Belichtungskopfes beim Start der Belichtung gesetzt werden können. Durch eine entsprechende Verschiebung des Startpunkts der Belichtung kann die beim Einspannen verursachte seitliche Verschiebung kompensiert werden, so dass die Lage der Belichtungsfläche auch mit Bezug auf die seitlichen Kanten des Aufzeichnungsmaterials immer gleich ist. Die Lage der seitlichen Kante sollte mit einer Genauigkeit von etwa 5µm ermittelt werden, da sonst durch das Aufaddieren von Einzelfehlern im weiteren Verarbeitungsprozess der Passerfehler der Farbauszüge im fertigen Druck zu groß werden kann.

In der Patentanmeldung EP 0 015 553 A1 wird eine Vorrichtung in einem Drucker zur Erkennung der seitlichen Kante eines Druckmediums, das auf eine Druckwalze gespannt ist, beschrieben, bei der ein Lichtstrahl auf die Druckwalze bzw. das Druckmedium gerichtet wird. Während der Lichtstrahl in axialer Richtung an der Druckwalze entlang bewegt wird, wird die Intensität des reflektierten Lichts gemessen. Unter der Voraussetzung, dass die Oberfläche der Druckwalze und das Druckmedium unterschiedliche Reflexionseigenschaften haben, kann die Lage der Kante des Druckmediums ermittelt werden.

In der Patentanmeldung EP 1 081 458 A2 wird eine Vorrichtung in einem Druckplattenbelichter zur Erkennung der seitlichen Kante einer Druckplatte, die auf eine Belichtungstrommel gespannt ist, beschrieben. Eine Laserdiode speist Licht in eine Lichtfaser ein, die das Licht radial auf die Belichtungstrommel bzw. die Druckplatte richtet. Mit einer Linsenanordnung wird das Licht auf die Oberfläche der Druckplatte fokussiert. Neben der Licht aussendenden Lichtfaser ist eine Licht aufnehmende Lichtfaser angeordnet, die mit einem Fotodetektor verbunden ist. Mit der gleichen Linsenanordnung wird das reflektierte Licht auf die Stirnfläche der aufnehmenden Lichtfaser fokussiert. Durch die Dicke der Druckplatte ergibt sich ein Höhenunterschied zwischen der Oberfläche der Belichtungstrommel und der Oberfläche der Druckplatte, und das ausgesendete Licht ist defokussiert, wenn es auf die Belichtungstrommel trifft. Dadurch wird eine größere Lichtmenge in die aufnehmende Lichtfaser zurückgeworfen als wenn das ausgesendete Licht auf die Druckplatte trifft. Infolge des Unterschieds der reflektierten Lichtmenge kann die Lage der Plattenkante erkannt werden, wenn die Anordnung axial an der Belichtungstrommel entlang bewegt wird. Da die Erkennung auf dem Höhenunterschied beruht, wird die Kante auch erkannt, wenn die Oberflächen der Belichtungstrommel und der Druckplatte die gleichen Reflexionseigenschaften haben.

Aus der GB 690056 ist es bekannt, eine Auskunft über eine seitliche Position eines Textilbandes zu erhalten, indem ein Lichtstrahl auf eine Fotodiode gerichtet ist, während ein Hebel zum einen in den Lichtstrahl hineinragt und zum anderen seitlich des bewegten Bandes positioniert ist. Seitliche Bewegungen des Bandes führen dann zu Verschwenkungen des Hebels und damit zu variierenden Lichteinstrahlungen auf der Fotodiode. Durch diese Signale der Fotodiode kann auf Änderungen der Position der Kante der Materialbahnen geschlossen werden.

In der Patentschrift US 5,220,177 A wird eine Vorrichtung zur Erkennung der Kanten eines bandförmigen lichtundurchlässigen oder halbtransparenten Materials beschrieben. Unterhalb des Materials ist ein Array von Licht emittierenden Dioden (LED) angeordnet, das auf beiden Seiten über das Bandmaterial hinausragt. Die LED haben einen Abstand von etwa 2,5 mm zueinander. Über dem Material ist ein Fotodetektor angeordnet. Die LED werden der Reihe nach eingeschaltet, wobei das Licht der LED, die sich in der Nähe einer Kante befinden, teilweise oder ganz durch das Bandmaterial abgedeckt wird. Dadurch wird das Signal im Fotodetektor um so mehr geschwächt, je dichter die LED an der Kante liegt. Nach einer Filterung und Glättung der Abschwächungskurve kann die Position der Kante genauer bestimmt werden, als es dem Abstand der LED entspricht.

EP1047260, US5956071 und EP1279920 sind auch Teil des Standes der Technik.

Die bekannten Verfahren zur Erkennung und Bestimmung der Lage der Kante eines Aufzeichnungsmaterials sind konstruktiv aufwendig oder sie erreichen nicht die geforderte Genauigkeit und Reproduzierbarkeit. Die Verwendung einer Gabellichtschranke erfordert, dass die Kante des Aufzeichnungsmaterials in den Spalt der Lichtschranke eintaucht. Da das Aufzeichnungsmaterial aber bereits bei der Messung auf eine Aufnahmefläche des Belichters aufgespannt ist, müsste eine relativ breite Vertiefung in die Aufnahmefläche eingebracht werden, in der sich eine Hälfte der Lichtschranke bewegt. Dadurch besteht die Gefahr, dass sich dort das Aufzeichnungsmaterial zur Aufnahmefläche hin einwölbt.

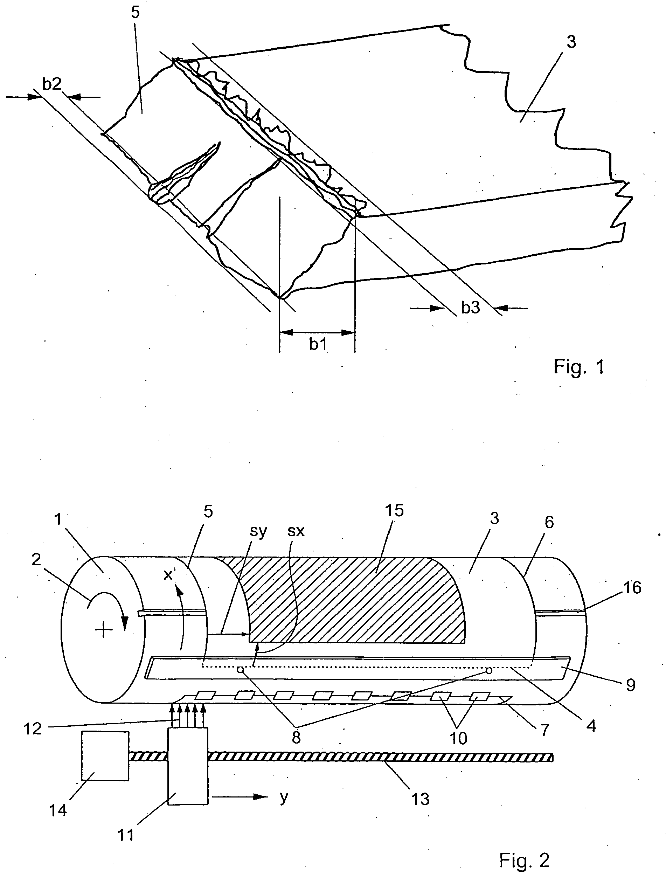

Die Verwendung einer Messeinrichtung, die von der Kante des Aufzeichnungsmaterials reflektiertes Licht auswertet, ist je nach der Beschaffenheit der Kante nicht zuverlässig und reproduzierbar genug. Fig. 1 zeigt dazu den vergrößerten Ausschnitt der linken Seitenkante 5 einer Druckplatte 3. Bedingt durch das Werkzeug, mit dem die Druckplatte 3 zugeschnitten wurde, kann die Kante 5 um einen Toleranzbereich b1 von der Senkrechten abweichen. Dadurch verändert sich das Reflexionsverhalten gegenüber einer idealen senkrechten Kante. Das Schneidwerkzeug verursacht auch Riefen, wodurch die Kante 5 in einem Toleranzbereich b2 von einer idealen Geraden abweicht. Schließlich ist am oberen Rand der Kante 5 die Beschichtung in einem Toleranzbereich b3 beschädigt oder abgeplatzt, so dass in diesem Bereich die Reflexionseigenschaften nicht eindeutig definiert sind. Die typischen Größen der drei Toleranzbereiche sind beispielsweise b1 = 70µm, b2 = 20µm, b3 = 100µm. Damit sind diese Toleranzen so groß, dass eine Kantenmessung mit reflektiertem Licht zu unsicher und zu ungenau wird.

Eine Kantenmessung mit optischen oder induktiven und kapazitiven Sensoren, die den Abstand zwischen dem Sensor und der Oberfläche des Aufzeichnungsmaterials bzw. der Auflagefläche für das Aufzeichnungsmaterial messen, und die Kante an der Veränderung dieses Abstands erkennen, ist problematisch, weil solche Sensoren mit einem relativ großen Messpunktdurchmesser arbeiten. Deshalb ist die geforderte Genauigkeit und Reproduzierbarkeit der Kantenmessung nur schwer zu erfüllen.

Die herkömmlichen Vorrichtungen zur Erkennung der Kante eines Aufzeichnungsmäterials erfordern eine aufwendige optische und mechanische Anordnung und einen beträchtlichen Aufwand für die elektronische Auswertung des Messsignals, um die Anforderungen an die Genauigkeit und Reproduzierbarkeit der Kantenmessung zu erfüllen. Nachteilig ist bei einigen Vorrichtungen auch, dass Licht auf das Aufzeichnungsmaterial gerichtet wird, um das reflektierte Licht auszuwerten. Dadurch kann lichtempfindliches Material störend belichtet werden, selbst wenn vorsorglich Sensorlicht verwendet würde, dessen Wellenlänge auβerhalb des spektralen Empfindlichkeitsbereichs des Aufzeichnungsmaterials liegt.

Es ist deshalb die Aufgabe der vorliegenden Erfindung, eine einfache und zuverlässige Vorrichtung zur Erkennung der Kante eines Aufzeichnungsmaterials anzugeben, die bei der Aufzeichnung von Druckvorlagen mit Vorteil verwendet werden kann. Eine weitere Aufgabe ist, ein mit der erfindungsgemäßen Vorrichtung ausführbares Verfahren anzugeben.

Nachfolgend werden die Vorrichtung und das Verfahren am Beispiel eines Auβentrommelbelichters für Druckplatten erläutert. Die Vorrichtung und das Verfahren sind aber prinzipiell ebenso auf Innentrommelbelichter oder Flachbettbelichter sowie auch auf andere Aufzeichnungsmaterialien anwendbar, wobei lediglich Details der konstruktiven Ausführung angepasst werden müssen. Die Erfindung wird anhand der Figuren näher beschrieben.

Es zeigen:
- Fig. 1: einen Ausschnitt der Kante einer Druckplatte,
- Fig. 2: den Aufbau eines Außentrommelbelichters,
- Fig. 3: eine erste Lösung für eine Tasteinrichtung,
- Fig. 4: eine zweite Lösung für eine Tasteinrichtung,
- Fig. 5: eine erste Ausführungsform für eine Tasteinrichtung, und
- Fig. 6: eine zweite Ausführungsform für eine Tasteinrichtung.

Fig. 2 zeigt den prinzipiellen Aufbau eines Außentrommelbelichters. Eine Belichtungstrommel 1 ist drehbar gelagert und kann mit einem nicht gezeigten Rotationsantrieb in Richtung des Rotationspfeils 2 in eine gleichmäßige Rotationsbewegung versetzt werden. Auf die Belichtungstrommel 1 ist eine unbelichtete, rechteckige Druckplatte 3 gespannt, die eine Vorderkante 4, eine linke Seitenkante 5, eine rechte Seitenkante 6 und eine Hinterkante 7 aufweist. Die Druckplatte 3 wird so aufgespannt, dass ihre Vorderkante 4 Anlagestifte 8 berührt, die mit der Belichtungstrommel 1 fest verbunden sind und über die Oberfläche der Belichtungstrommel 1 hinausragen. Eine Klemmleiste 9 drückt die Vorderkante 4 außerdem fest auf die Oberfläche der Belichtungstrommel 1 und fixiert dadurch die Vorderkante 4 der Druckplatte 3. Die Druckplatte 3 wird flächig mittels einer in Fig. 2 nicht gezeigten Vakuumeinrichtung, die die Druckplatte 3 durch Löcher in der Trommeloberfläche ansaugt, auf der Trommeloberfläche gehalten, damit die Druckplatte 3 nicht durch die Fliehkräfte bei der Rotation abgelöst wird. Zusätzlich wird die Hinterkante 7 der Druckplatte 3 mit Klemmstücken 10 fixiert.

Ein Belichtungskopf 11 wird in einem relativ kurzen Abstand axial an der Belichtungstrommel 1 entlang bewegt, während die Belichtungstrommel 1 rotiert. Der Belichtungskopf 11 fokussiert einen oder mehrere Laserstrahlen 12 auf die Trommeloberfläche, die die Trommeloberfläche in Form von engen Schraubenlinien überstreichen. Auf diese Weise werden bei jeder Trommelumdrehung eine bzw. mehrere Bildlinien in der Umfangsrichtung x auf das Aufzeichnungsmaterial belichtet. Der Belichtungskopf 11 wird in der Vorschubrichtung y mittels einer Vorschubspindel 13 bewegt, mit der er formschlüssig verbunden ist und die mit einem Vorschubantrieb 14 in Drehbewegung versetzt wird. Vorzugsweise ist der Vorschubantrieb 14 mit einem Schrittmotor aufgebaut. Durch Zählen der Schrittmotortakte kann dann ausgehend von einer bekannten Referenzposition die aktuelle axiale y-Position des Belichtungskopfes 11 sehr genau ermittelt werden. Alternativ kann auf der Drehachse des Vorschubantriebs 14 ein in Fig. 2 nicht gezeigter Drehwinkelgeber angebracht sein, der nach einem bestimmten Drehwinkelinkrement der Vorschubspindel 13 jeweils ein Taktsignal erzeugt. Durch Zählen dieser Takte kann ebenfalls die y-Position des Belichtungskopfes 11 ermittelt werden.

Die auf der Druckplatte 3 zu belichtende Druckvorlage 15 bedeckt nur einen Teil der gesamten zur Verfügung stehenden Aufzeichnungsfläche. Die Druckvorlage 15 muss jedoch für alle Farbauszüge, die nacheinander auf verschiedene Druckplatten 3 belichtet werden, immer die gleiche Lage bezüglich der Kanten der Druckplatte 3 haben, damit später beim Übereinanderdruck der Farbauszüge keine Passerfehler auftreten, d.h der Abstand sx des vorderen Rands der Druckvorlage 15 zur Vorderkante 4 der Druckplatte 3 und der Abstand sy des linken Rands der Druckvorlage 15 zur linken Seitenkante 5 der Druckplatte 3 müssen für alle Farbauszüge gleich sein. Da die Kanten der Druckplatte 3 nicht ideal gerade sind, wird die Lage der zu belichtenden Druckvorlage 15 bei genauer Betrachtung mit Bezug auf drei Punkte auf den Kanten bestimmt, zwei Punkte an der Vorderkante 4, dort wo die Anlagestifte 8 die Vorderkante 4 berühren, und ein Punkt an einer Seitenkante, dort wo eine entsprechende Messvorrichtung die Lage der Seitenkante ermittelt. Durch eine in Fig. 2 nicht gezeigte axiale Vorzentrierung der Druckplatte 3 wird beim Aufspannen der Druckplatte 3 auf die Belichtungstrommel 1 dafür gesorgt, dass bei allen Druckplatten des gleichen Formats die Druckplatte 3 die Anlagestifte 8 innerhalb eines Toleranzbereichs im wesentlichen an den gleichen Punkten der Vorderkante 4 berührt. Auch die Messung der Seitenkante erfolgt bei allen Druckplatten am gleichen Punkt der Seitenkante. Diese drei Punkte werden ebenso in weiteren Einheiten, in denen die Druckplatte 3 verarbeitet wird, z.B. in einer Plattenstanze, als Bezugspunkte herangezogen.

Die Einhaltung des Abstands sx wird dadurch erreicht, dass die Druckplatte 3 beim Aufspannen auf die Belichtungstrommel 1 an die Anlagestifte 8 angelegt wird und ausgehend von dieser bekannten Umfangsposition der Startpunkt der Belichtung für die Bildlinien um den Abstand sx in x-Richtung verschoben wird. Die Verschiebung erfolgt beispielsweise durch das Zählen von Umfangstakten, die von einem in Fig. 2 nicht gezeigten mit der Trommelachse verbundenen Drehwinkelgeber abgeleitet werden.

Bei der Einhaltung des Abstands sy tritt das Problem auf, dass die Druckplatte 3 beim Aufspannen auf die Belichtungstrommel 1 durch mechanische Toleranzen der Einspannvorrichtung eine kleine Verschiebung in y-Richtung erfahren kann. Um den Abstand sy genau einhalten zu können, ist es deshalb erforderlich, die genaue Lage der linken Seitenkante 5 der Druckplatte 3 nach dem Einspannen zu ermitteln. Die ermittelte Kantenposition kann dann in Beziehung zur Position des Belichtungskopfes 11 gesetzt werden und durch eine entsprechende Verschiebung des Startpunkts der Belichtung in y-Richtung kann die beim Einspannen verursachte axiale Verschiebung der Druckplatte 3 kompensiert werden. Die Bestimmung des richtigen Startpunkts für die Belichtung geschieht durch Zählen der Takte, mit denen der Vorschubantrieb 14 gesteuert wird.

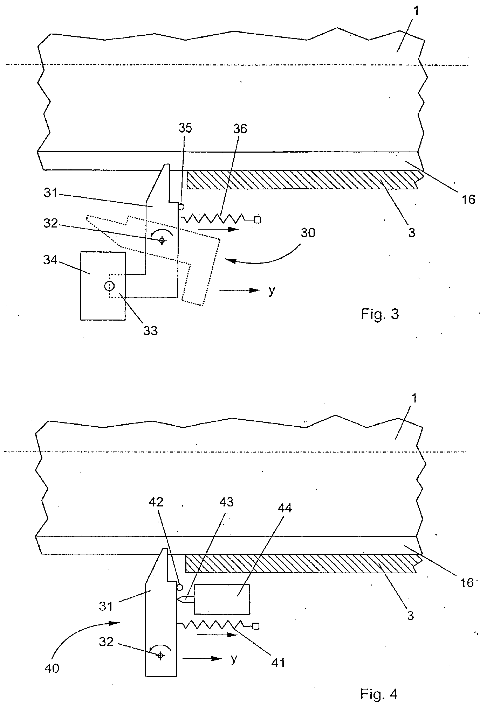

Nach der erfindungsgemäßen Vorrichtung und für das Verfahren zur Bestimmung der Lage einer Seitenkante der Druckplatte 3 ist eine Tasteinrichtung 30 mit einem Tastfinger 31 vorgesehen, der in eine schmale Nut 16 in der Oberfläche der Belichtungstrommel 1, die sich in axialer Richtung der Belichtungstrommel 1 erstreckt, eingeschwenkt werden kann. Fig. 3 zeigt dazu eine erste Lösung in einer Längsschnittsansicht der Belichtungstrommel 1. Bei still stehender Belichtungstrommel 1 wird ein Tastfinger 31, der in einer Drehachse 32 drehbar gelagert ist, in die Nut 16 eingeschwenkt. In dieser Stellung wird er gehalten, indem er durch eine Federkraft 36 gegen einen Anschlagstift 35 gedrückt wird. Wenn die Lage der Kante nicht gemessen wird, wird der Tastfinger 31 aus der Nut 16 herausgeschwenkt, damit er die Oberfläche der Druckplatte 3 nicht beschädigen kann. Die herausgeschwenkte Stellung ist in Fig. 3 gestrichelt eingezeichnet. An einem Ende ist der Tastfinger 31 mit einer Fahne 33 versehen, die im eingeschwenkten Zustand des Tastfingers 31 in den Lichtspalt einer Gabellichtschranke 34 ragt. Die gesamte Tasteinrichtung 30 ist fest mit dem Belichtungskopf 11 verbunden und wird mittels des Vorschubantriebs 14 zusammen mit dem Belichtungskopf 11 axial in y-Richtung an der Belichtungstrommel 1 entlang bewegt. Sobald der Tastfinger 31 die Kante der Druckplatte 3 berührt, dreht sich der Tastfinger beim Weiterbewegen der Tasteinrichtung 30 ein wenig, so dass sich die Fahne 33 aus dem Lichtweg der Lichtschranke 34 herausbewegt und ein elektrisches Signal abgibt. Die Tasteinrichtung 30 bewegt sich in sehr kleinen Schritten auf die Plattenkante zu, beispielsweise um 0,2 µm je Takt des Vorschubantriebs 14. Durch Zählen der Takte kann die y-Position ermittelt werden, bei der das Signal abgegeben wird, und somit die Lage der Plattenkante bestimmt werden.

Fig. 4 zeigt eine weitere Lösung für die erfindungsgemäße Vorrichtung. Ein Tastfinger 31, der in einer Drehachse 32 drehbar gelagert ist, wird zum Messen der Plattenkante in die Nut 16 eingeschwenkt. Wenn die Lage der Kante nicht gemessen wird, wird der Tastfinger 31 aus der Nut 16 herausgeschwenkt. Die herausgeschwenkte Stellung ist in Fig. 4 wegen der besseren Übersichtlichkeit nicht dargestellt. Der Tastfinger 31 wird mit einer Federkraft 41 gegen einen Anschlagstift 42 gedrückt, wodurch der Tastfinger 31 den Schaltstift 43 eines Mikroschalters 44 eindrückt. Die gesamte Tasteinrichtung 40 ist fest mit dem Belichtungskopf 11 verbunden und wird mittels des Vorschubantriebs 14 zusammen mit dem Belichtungskopf 11 axial in y-Richtung an der Belichtungstrommel 1 entlang bewegt. Nachdem der Tastfinger 31 die Kante der Druckplatte 3 berührt hat, dreht sich der Tastfinger ein wenig, so dass sich der Schaltstift 43 mittels einer im Mikroschalter 44 vorhandene Feder aus dem Mikroschalter 44 herausbewegt und einen elektrischen Kontakt schließt. Durch Zählen der Takte des Vorschubantriebs 14 kann die y-Position ermittelt werden, bei der der Kontakt geschlossen wird, und somit die Lage der Plattenkante bestimmt werden. Der Mikroschalter 44 ist vorzugsweise ein Präzisionsschalter, der bereits bei einem Schaltweg von 1...2 µm des Schaltstifts 43 den Kontakt schließt bzw. öffnet.

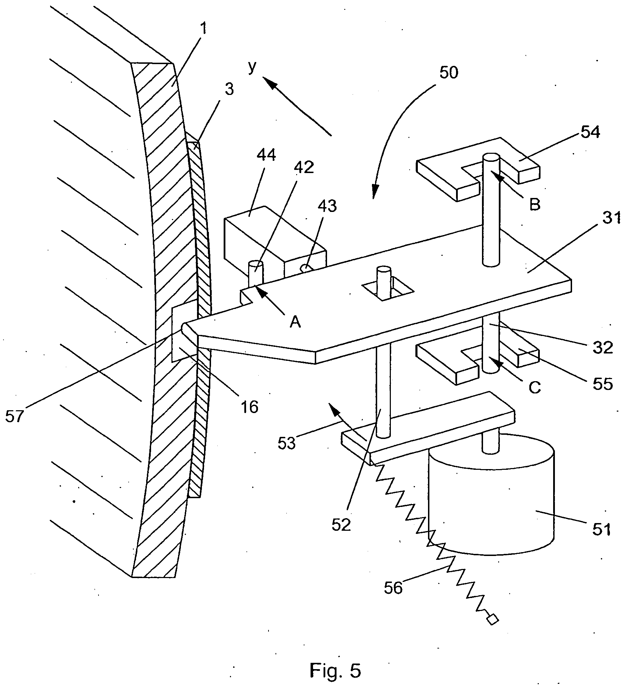

Fig. 5 zeigt eine Tasteinrichtung 50 als bevorzugte Ausführungsform der Lösung nach Fig. 4. Dargestellt ist eine perspektivische Sicht auf einen Ausschnitt der Belichtungstrommel 1 mit der eingearbeiteten Nut 16 und der aufgespannten Druckplatte 3. Der Tastfinger 31 und seine Drehachse 32 sind fest miteinander verbunden. Die Enden der Drehachse 32 sind in nicht gezeigten Lagern drehbar gelagert. Ein Motor 51 bewegt über eine Kurbelverbindung einen Mitnahmestift 52 in Richtung des Pfeils 53. Der Mitnahmestift 52 greift etwa in der Mitte des Tastfingers 31 ein und drückt den Tastfinger 31 in einem ersten Auflagepunkt A gegen den Anschlagstift 42 und seine Drehachse 32 in zwei weiteren Auflagepunkten B und C gegen definierte Anschlagflächen 54 und 55. Die drei Auflagepunkte sind mit den Pfeilen A, B und C gekennzeichnet. Der Motor 51 ist vorzugsweise ein Drehmomentmotor, der auch im Stillstand ein durch den Stromfluss einstellbares Drehmoment ausübt: Beim Einschwenken des Tastfingers 31 in die Nut 16 wird der Strom des Motors 51 nach einer Rampenfunktion erhöht, wodurch sich der Tastfinger 31 langsam in die eingeschwenkte Stellung dreht, bis er den Anschlagstift 42 berührt. Dadurch wird vermieden, dass der Tastfinger 31 oder der Anschlagstift 42 durch zu hartes Anschlagen an den Anschlagstift 42 verformt wird oder verschleißt, so dass die Genauigkeit und Reproduzierbarkeit der Messung beeinträchtigt würde. Nach dem Einschwenken drückt der Motor 51 den Tastfinger 31 mit einem konstanten Drehmoment gegen die Zugkraft einer Rückholfeder 56 gegen den Anschlagstift 42 und erfüllt damit die Funktion der Federkraft 41 (Fig. 4). Mit dem konstanten Drehmoment des Motors 51 wird auch eine definierte Kraft auf die Kante der Druckplatte 3 ausgeübt, sobald der Tastfinger 31 die Kante berührt. Eine Rundung 57 des Tastfingers 31 in dem Bereich, in dem er die Plattenkante berührt, ist eine weitere Voraussetzung für die definierte und immer gleiche Kraft, die der Tastfinger 31 auf die Plattenkante ausübt. Der Motor 51 wird in Gegenrichtung des Pfeils 53 gedreht, wenn der Tastfinger 31 aus der Nut 16 heraus geschwenkt werden soll.

Wenn die Tasteinrichtung 50 in y-Richtung an der Trommel entlang bewegt wird und der Tastfinger 31 gegen die Kante der Druckplatte 3 stößt, wird der Tastfinger 31 nur am Auflagepunkt A abgehoben. Die Auflagepunkte B und C liegen weiterhin an, da die Drehachse 32 durch den Mitnahmestift 52 gegen die Auflageflächen 54 und 55 gedrückt wird. Durch die drei Auflagepunkte A, B und C und die Oberflächengüte der zugehörigen Auflageflächen in Verbindung mit der Federwirkung des Motors 51 wird die benötigte Präzision und Reproduzierbarkeit der Tasteinrichtung 50 im Bereich weniger Mikrometer erreicht. Diese Genauigkeit wird erreicht, ohne dass eine spielfreie Lagerung der Drehachse 32 des Tastfingers 31 benötigt wird.

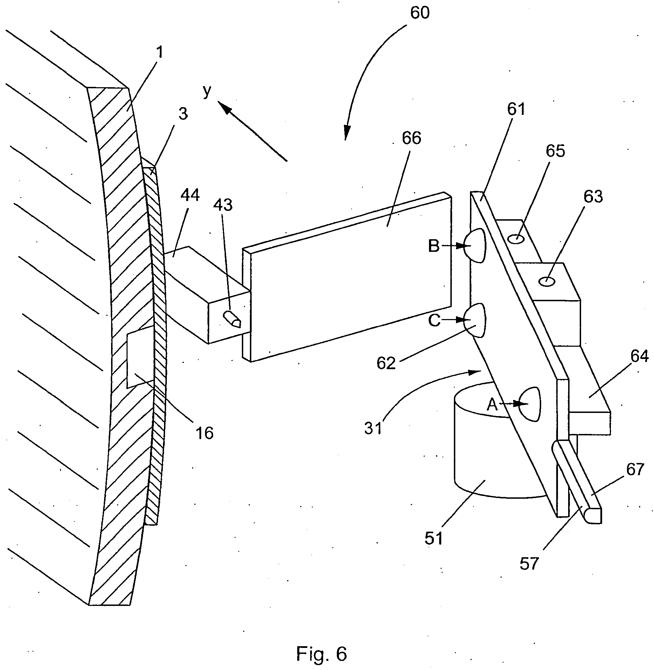

Fig. 6 zeigt eine Tasteinrichtung 60 als alternative Ausführungsform der Lösung nach Fig. 4. Der Tastfinger 31 ist wegen der besseren Übersichtlichkeit in herausgeschwenkter Stellung gezeichnet. Er besteht aus einer Platte 61, auf der drei Halbkugelelemente 62 als Auflagepunkte A, B, und C angebracht sind. Die Platte 61 ist über ein bewegliches Gelenk 63 mit einem Dreharm 64 verbunden, der wiederum fest mit der Drehachse 65 des Motors 51 verbunden ist. Das Gelenk 63 ist in allen Raumrichtungen etwas beweglich, so dass nach dem Hineinschwenken des Tastfingers 31 in die Nut 16 alle Auflagepunkte auf einer Auflageplatte 66 sicher aufliegen. Das Gelenk 63 ist etwa in der Mitte der drei Auflagepunkte A, B und C angebracht, damit die durch den Dreharm 64 auf den Tastfinger 31 ausgeübte Kraft auf die drei Auflagepunkte gleichmäßig verteilt wird. In der eingeschwenkten Stellung des Tastfingers 31 drückt der vordere Teil der Platte 61 den Schaltstift 43 des Mikroschalters 44 hinein, und ein Ausleger Platte 61 den Schaltstift 43 des Mikroschalters 44 hinein, und ein Ausleger 67 mit der Rundung 57 an seiner Vorderkante ragt in die Nut 16 hinein. Auch mit der Tasteinrichtung 60 wird nur durch die drei Auflagepunkte A, B und C und die zugehörige Auflageplatte 66 die geforderte Genauigkeit und Wiederholbarkeit bei der Messung der Lage einer Druckplattenkante erreicht, ohne dass eine spielfreie Lagerung der Motorachse 62 erforderlich ist.

Um keine Justage des Mikroschalters 44 und des Anschlagstifts 42 bzw. der Auflageplatte 66 zueinander mit einer Genauigkeit im Mikrometerbereich vornehmen zu müssen, wird bei den Tasteinrichtungen 50 bzw. 60 der Mikroschalter 44 so montiert, dass sein Schaltstift 43 genügend weit eingedrückt wird, wenn der Tastfinger 31 an den drei Auflagepunkten A, B und C anliegt. Dann wird die ganze Tasteinheit kalibriert, indem in einer Messeinrichtung bestimmt wird, welchen Weg die Spitze des Tastfingers 31, die später die Kante der Druckplatte 3 berührt, entgegen der y-Richtung zurücklegen muss, bis sich der Kontakt des Mikroschalters 44 schließt. Diese gemessene Wegstrecke wird nach dem Einbau in den Belichter in der Steuerung des Belichters gespeichert und bei der Bestimmung der genauen Lage der Plattenkante als Korrekturwert eingerechnet. Dieser Korrekturwert kann aber auch ohne eine externe Kalibriereinrichtung durch eine einfache Testbelichtung bestimmt werden, wobei die Lage der Plattenkante zunächst ohne den Korrekturwert mit der Tasteinrichtung 50 bzw. 60 ermittelt wird. Nach der Testbelichtung wird auf dem Aufzeichnungsmaterial ausgemessen, um welchen Betrag die belichtete Fläche in y-Richtung gegenüber der Solllage verschoben ist. Die Differenz ist der Korrekturwert.

Wenn in verschiedenen Einheiten, in denen die Druckplatte 3 verarbeitet wird, z.B. in einem Belichter und in einer Plattenstanze, die Plattenkante jeweils mit einer der beschriebenen Tasteinrichtungen (40; 50; 60) gemessen wird, ist für eine hohe Genauigkeit der Messung zu beachten, dass die Rundung 57 des Tastfingers 31 und die Andruckkraft an die Plattenkante in allen Fällen gleich ist. Auβerdem muss in allen Einheiten der Punkt auf der Seitenkante, an dem der Tastfinger 31 die Druckplatte 3 berührt, gleich weit von der Vorderkante 4 entfernt sein.

### Bezugszeichenliste

- 1: Belichtungstrommel
- 2: Rotationspfeil
- 3: Druckplatte
- 4: Vorderkante
- 5: linke Seitenkante
- 6: rechte Seitenkante
- 7: Hinterkante
- 8: Anlagestift
- 9: Klemmleiste
- 10: Klemmstück
- 11: Belichtungskopf
- 12: Laserstrahl
- 13: Vorschubspindel
- 14: Vorschubantrieb
- 15: Druckvorlage
- 16: Nut
- 30: Tasteinrichtung
- 31: Tastfinger
- 32: Drehachse
- 33: Fahne
- 34: Lichtschranke
- 35: Anschlagstift
- 36: Federkraft
- 40: Tasteinrichtung
- 41: Federkraft
- 42: Anschlagstift
- 43: Schaltstift
- 44: Mikroschalter
- 50: Tasteinrichtung
- 51: Motor
- 52: Mitnahmestift
- 53: Pfeil
- 54: Anschlagfläche
- 55: Anschlagfläche
- 56: Rückholfeder
- 57: Rundung
- 60: Tasteinrichtung
- 61: Platte
- 62: Halbkugelelement
- 63: Gelenk
- 64: Dreharm
- 65: Drehachse
- 66: Auflageplatte
- 67: Ausleger

## Patentansprüche

1. Vorrichtung zur Aufzeichnung von Druckvorlagen (15) auf ein Aufzeichnungsmaterial, bestehend aus
- einer Belichtungstrommel (1) zur Aufnahme des Aufzeichnungsmaterials, und
- einem Belichtungskopf (11), der axial an der Belichtungstrommel (1) entlang bewegt wird und Belichtungsstrahlen (12) auf das Aufzeichnungsmaterial fokussiert,
**gekennzeichnet durch**
eine Tasteinrichtung (30; 40; 50; 60) bestehend aus
- einem Tastfinger (31), der in eine Nut (16) in der Oberfläche der Belichtungstrommel (1) eingeschwenkt wird, und
- einem Sensor, der ein Signal abgibt, wenn der Tastfinger (31) sich bei der Berührung der Seitenkante des Aufzeichnungsmaterials bewegt.

2. Vorrichtung nach Anspruch 1, **dadurch gekennzeichnet, dass** der Sensor eine Lichtschranke (34) ist.

3. Vorrichtung nach Anspruch 1, **dadurch gekennzeichnet, dass** der Sensor ein Mikroschalter (44) ist.

4. Vorrichtung nach Anspruch 1, **gekennzeichnet durch** eine feste Verbindung der Tasteinrichtung (30; 40; 50; 60) mit dem Belichtungskopf (11).

5. Vorrichtung nach Anspruch 3, **gekennzeichnet durch** drei Auflagepunkte (A; B; C), an denen der Tastfinger (31) und eine mit ihm fest verbundene Drehachse (32) anliegen.

6. Vorrichtung nach Anspruch 5, **gekennzeichnet durch** einen Mitnahmestift (52) der angetrieben von einem Motor (51) den Tastfinger (31) und die Drehachse (32) an die drei Auflagepunkte (A; B; C) andrückt.

7. Vorrichtung nach Anspruch 3, **gekennzeichnet durch** drei Auflagepunkte (A; B; C), die an dem Tastfinger (31) herausstehen.

8. Vorrichtung nach Anspruch 7, **gekennzeichnet durch** ein Gelenk (63), das den Tastfinger mit einem Dreharm (64) verbindet, der angetrieben von einem Motor (51) den Tastfinger (31) mit den drei Auflagepunkten (A; B; C) an eine Auflageplatte (66) drückt.

9. Verfahren zur Erkennung der Kante eines Aufzeichnungsmaterials in einem Belichter zur Aufzeichnung von Druckvorlagen (15), bestehend aus
- einer Belichtungstrommel (1) zur Aufnahme des Aufzeichnungsmaterials, und
- einem Belichtungskopf (11), der axial an der Belichtungstrommel (1) entlang bewegt wird und Belichtungsstrahlen (12) auf das Aufzeichnungsmaterial fokussiert,
**dadurch gekennzeichnet, dass**
- ein Tastfinger (31) in eine Nut (16) in der Oberfläche der Belichtungstrommel (1) eingeschwenkt wird, und
- mit einem Sensor ein Signal erzeugt wird, wenn der Tastfinger (31) sich bei der Berührung der Seitenkante des Aufzeichnungsmaterials bewegt.

10. Verfahren nach Anspruch 9, **dadurch gekennzeichnet, dass** der Tastfinger (31) und der Sensor mit einem Vorschubantrieb (14) axial an der Belichtungstrommel (1) entlang bewegt werden.

11. Verfahren nach Anspruch 10, **dadurch gekennzeichnet, dass** die axiale Position der Kante des Aufzeichnungsmaterials durch Zählen der Takte des Vorschubantriebs (14) bestimmt wird.

## Claims

1. Device for recording printing originals (15) on a recording material, consisting of
- an exposure drum (1) for receiving the recording material and
- an exposure head (11) that is moved axially along the exposure drum (1) and focuses exposure beams (12) onto the recording material,
**characterized by**
a sensing device (30; 40; 50; 60) consisting of
- a sensing finger (31) that is pivoted into a groove (16) in the surface of the exposure drum (1) and
- a sensor outputting a signal when the sensing finger (31) moves as it touches the lateral edge of the recording material.

2. Device according to Claim 1,
**characterized in**
**that** the sensor is a light barrier (34).

3. Device according to Claim 1,
**characterized in**
**that** the sensor is a microswitch (44).

4. Device according to Claim 1,
**characterized by**
a firm connection between the sensing device (30; 40; 50; 60) and the exposure head (11).

5. Device according to Claim 3,
**characterized by**
three points of contact (A; B; C) which are contacted by the sensing finger (31) and an axis of rotation (32) firmly connected to the latter.

6. Device according to Claim 5,
**characterized by**
a driver pin (52) driven by a motor (51) and pressing the sensing finger (31) and the axis of rotation (32) against the three points of contact (A; B; C).

7. Device according to Claim 3,
**characterized by**
three points of contact (A; B; C) projecting from the sensing finger (31).

8. Device according to Claim 7,
**characterized by**
a joint (63) connecting the sensing finger to a rotary arm (64), the rotary arm being driven by a motor (51) and pressing the sensing finger (31) with the three contact points against a contact plate (66).

9. Method for detecting the edge of a recording material in an exposer for recording printing originals (15), the exposer consisting of
- an exposure drum (1) for receiving the recording material, and
- an exposure head (11) that is moved axially along the exposure drum (1) and focuses exposure beams (12) onto the recording material,
**characterized in**
- **that** a sensing finger (31) is pivoted into a groove (16) in the surface of the exposure drum (1), and
- **that** a sensor generates a signal when the sensing finger (31) moves as it touches the lateral edge of the recording material.

10. Method according to claim 9,
**characterized in**
**that** the sensing finger (31) and the sensor are moved axially along the exposure drum (1) by means of a feed drive (14).

11. Method according to claim 10,
**characterized in**
**that** the axial position of the edge of the recording material is determined by calculating the cycles of the feed drive (14).

## Revendications

1. Procédé pour l'enregistrement de modèles d'impression (15) sur un matériau d'enregistrement se composant
- d'un tambour d'illumination (1) pour l'enregistrement du support d'enregistrement et
- une tête d'illumination (11) qui est déplacée axialement le long du tambour d'illumination (1) et les rayons d'illuminations (12) sont focalisés sur le matériau d'enregistrement,
**caractérisé par**
un dispositif de touches (30 ; 40 ; 50, 60) qui se compose de
- d'un doigt tactile (31) qui est introduit dans une rainure (16) à la surface du tambour d'illumination, et
- un capteur émettant un signal quand le doigt tactile (31 se déplace lors du contact du bord latéral du moyen d'enregistrement.

2. Dispositif selon la revendication 1, **caractérisé en ce que** le capteur est une barrière photo-électrique (34).

3. Dispositif selon la revendication 1, **caractérisé en ce que** le capteur est un microinterrupteur (44).

4. Dispositif selon la revendication 1, **caractérisé par** une connexion fixe du dispositif de touches (30 ; 40 ; 50, 60) à la tête d'illumination (11).

5. Dispositif selon la revendication3, **caractérisé par** trois points d'applications (A<, B<. C) sur lesquels s'appliquent le doit de contact (31) et un axe rotatif (32) relié fermement avec un axe de rotation (32) est appliqué au doigt tactile (31).

6. Dispositif selon la revendication 5, **caractérisé par** un ergot d'entraînement (52) qui est entraîné par un moteur (51) qui entraîne le doigt tactile (31) et presse l'axe de rotation (32) sur les trois points d'application (A ; B ; C).

7. Dispositif selon la revendication 3, **caractérisé par** trois points d'application (A ; B ; C) qui dépassent sur le doigt tactile (31).

8. Dispositif selon la revendication 7, **caractérisé par** une articulation (63) qui relie le doigt tactile à un bras rotatif (64) qui est entraîné par un moteur (51) et presse le doigt tactile avec les points d'application (A ; B ; C) sur une plaque d'application (66).

9. Procédé pour la détection du bord d'un matériau d'enregistrement dans un système d'exposition pour l'enregistrement de modèles d'impression (13) se composant
- d'un tambour d'exposition (1) pour l'enregistrement du matériau d'enregistrement et
- une tête d'exposition (11) qui est déplacée axialement sur le tambour d'exposition et des rayons d'exposition (12) sont centrés sur le matériau d'enregistrement,
**caractérisé en ce**
- **qu'**un doigt tactile (31) est basculé dans une rainure (16) dans la surface du tambour d'illumination (1), et
- un signal est généré par un capteur si le doigt tactile (31) se déplace lors du contact avec le bord latéral du matériau d'enregistrement.

10. Procédé selon la revendication 9, **caractérisé en ce que** le doigt tactile (31) et le capteur sont déplacés par un entraînement d'avance (14) axialement le long du tambour d'illumination (1).

11. Procédé selon la revendication 10, **caractérisé en ce que** la position axiale du bord du matériel d'enregistrement est définie par comptage des temps de l'entraînement d'avance (14).
